# EUROPEAN PATENT APPLICATION

(11) **EP 4 783 461 A1**
(43) Date of publication of application: **29.07.2026**
(21) Application number: 24876398.9
(22) Date of filing: 25.09.2024
(51) Int. Cl.: H03H 9/17, H03H 9/56

(54) **RESONATOR, FILTER AND COMMUNICATION APPARATUS**

(30) Priority: 13.10.2023 CN 202311334857
(71) Applicant: HUAWEI TECHNOLOGIES CO., LTD., Shenzhen 518129 (CN)
(72) Inventor: HUANG, Xuanqi, Shenzhen, Guangdong 518129 (CN); LI, Xinyi, Shenzhen, Guangdong 518129 (CN); WANG, Chao, Shenzhen, Guangdong 518129 (CN)
(74) Representative: Grünecker Patent- und Rechtsanwälte PartG mbB
(86) International application number: PCT/CN2024/121196
(87) International publication number: WO 2025/077580

(57) **Abstract**

Embodiments of this application provide a resonator, a filter, and a communication device, to resolve a problem that a large area is occupied on a layout of a circuit substrate when the resonator is cooperated with another component. The resonator includes a substrate and a resonance layer. The resonance layer is located on one side of the substrate, the resonance layer includes a first electrode, a second electrode, and a piezoelectric layer that are stacked, and the piezoelectric layer is located between the first electrode and the second electrode. At least one of the substrate, the first electrode, the second electrode, and the piezoelectric layer is a reference layer, an edge of the reference layer includes a first side surface and a second side surface that are adjacent to each other, and an included angle between the first side surface and the second side surface and located in the reference layer is a reflex angle. In the resonator provided in this application, the two side surfaces that form an inner angle set as the reflex angle in the reference layer enclose a semi-enclosed region, and the resonator is tightly combined with the another component in the filter on the circuit substrate via the semi-enclosed region, to improve utilization of the layout of the circuit substrate.

## Description

This application claims priority to Chinese Patent Application No. 202311334857.2, filed with the China National Intellectual Property Administration on October 13, 2023 and entitled "RESONATOR, FILTER, AND COMMUNICATION DEVICE", which is incorporated herein by reference in its entirety.

### TECHNICAL FIELD

This application relates to the field of electronic components, and in particular, to a resonator, a filter, and a communication device.

### BACKGROUND

With the advent of big data and internet of things era, a filter assembled in a communication device is bound to develop toward directions of low loss, miniaturization, integration, and the like. A bulk acoustic wave (bulk acoustic wave, BAW) resonator based on a piezoelectric material is a common filter solution. A high-performance filter can be built based on a high-performance BAW resonator and a specific circuit structure.

As the filter develops toward the directions of low loss, miniaturization, integration, and the like, the filter imposes a higher requirement on flexibility and the like of the resonator. However, in a related technology, a large area is occupied on a layout of a circuit substrate when a resonator is cooperated with another component.

### SUMMARY

Embodiments of this application provide a resonator, a filter, and a communication device, to resolve a problem that a large area is occupied on a layout of a circuit substrate when the resonator is cooperated with another component.

To achieve the foregoing objective, the following technical solutions are used in embodiments of this application.

According to one aspect, a resonator is provided. The resonator includes a substrate and a resonance layer. The resonance layer is located on one side of the substrate, the resonance layer includes a first electrode, a second electrode, and a piezoelectric layer that are stacked, and the piezoelectric layer is located between the first electrode and the second electrode. At least one of the substrate, the first electrode, the second electrode, and the piezoelectric layer is a reference layer, an edge of the reference layer includes a first side surface and a second side surface that are adjacent to each other, and an included angle between the first side surface and the second side surface and located in the reference layer is a reflex angle.

In the resonator provided in the foregoing embodiment of this application, at least one inner angle is set as a reflex angle in the reference layer, and then at a position of the inner angle being the reflex angle, the first side surface and the second side surface that are adjacent to each other form a region recessed into the reference layer, namely, form a semi-enclosed region. When the resonator is electrically connected to another component on a circuit substrate of a filter, the resonator may semi-enclose the another component on the circuit substrate via the semi-enclosed region. The resonator is more tightly combined with the another component on the circuit substrate. This reduces an area occupied by the resonator and the component combined with the resonator on the circuit substrate, and improves utilization of a layout of the circuit substrate. In addition, when the circuit substrate has a same quantity of components, the resonator is tightly combined with the another component on the circuit substrate in embodiments of this application. This reduces a layout area occupied by the component, and helps reduce the layout area of the circuit substrate.

In some embodiments, the edge of the reference layer includes a plurality of side surfaces that are sequentially head-to-tail connected, and any two of the plurality of side surfaces are not parallel. In the foregoing disposition, a transverse mode of a bulk acoustic wave generated by the resonator is suppressed, and performance of the resonator is improved.

In some embodiments, at least one side surface includes a plane, and/or at least one side surface includes an arc surface. In the foregoing disposition, when the plurality of side surfaces in the resonator provided in embodiments of this application are all planes, operating performance of the resonator can be effectively improved; or when the plurality of side surfaces in the resonator provided in embodiments of this application have an arc surface, flexibility of adapting the resonator to another component can be effectively improved.

In some embodiments, a chamfer or a fillet exists between two adjacent side surfaces. The foregoing disposition can further reduce a likelihood of parallelism between the plurality of side surfaces, and suppress the transverse mode.

In some embodiments, at least one of the substrate, the first electrode, the second electrode, and the piezoelectric layer is a non-reference layer, and the edge of the reference layer extends beyond an edge of the non-reference layer. The foregoing disposition can avoid obstructing, due to an edge of a film layer of the non-reference layer extending beyond an edge of a film layer of the reference layer, the another component to be combined with the resonator on the circuit substrate.

In some embodiments, the substrate is the reference layer, and in any two film layers in the resonance layer, an edge of a film layer close to the substrate extends beyond an edge of a film layer far away from the substrate. In the foregoing disposition, the substrate is used as the reference layer, so that support stability of a bottom of the resonator can be increased, and stability of an overall structure of the resonator is improved.

In some embodiments, shapes of orthogonal projections of any two film layers of the substrate, the first electrode, the second electrode, and the piezoelectric layer on a reference plane are the same, and the reference plane is perpendicular to a direction in which the substrate and the resonance layer are stacked. The foregoing disposition helps reduce impedance of an anti-resonant frequency of the resonator while ensuring stability of the overall structure of the resonator, and improve an effective electromechanical coupling coefficient of the resonator.

In some embodiments, the reference layer includes the first side surface, the second side surface, a third side surface, a fourth side surface, a fifth side surface, and a sixth side surface that are sequentially head-to-tail connected. Included angles between the first side surface and the sixth side surface, between the second side surface and the third side surface, and between the fourth side surface and the fifth side surface and located in the reference layer are obtuse angles. Included angles between the third side surface and the fourth side surface, and between the fifth side surface and the sixth side surface and located in the reference layer are acute angles. In the foregoing disposition, an angle of each included angle can be changed to implement change of extension directions of two side surfaces that form the included angle, so that the formed reference layer has a regular shape. This helps combine and splice the resonator with the another component on the layout of the circuit substrate.

In some embodiments, the substrate has a cavity. The resonance layer and the cavity overlap in a first direction, and the first direction is the direction in which the substrate and the resonance layer are stacked. In the foregoing disposition, a free-standing bulk acoustic resonator can be formed, and an effective region is formed via an overlapping region of the resonance layer and the cavity, used as a region for triggering a resonance effect.

In some embodiments, the resonator further includes a reflection layer. The reflection layer is located between the substrate and the resonance layer, and the resonance layer and the reflection layer overlap in a first direction. The reflection layer includes a high acoustic impedance layer and a low acoustic impedance layer that are alternately stacked in the first direction, and the first direction is the direction in which the substrate and the resonance layer are stacked. In the foregoing disposition, a solid-mounted resonator can be formed, and an effective region is formed via an overlapping region of the resonance layer and the reflection layer, used as a region for triggering a resonance effect.

According to another aspect, a filter is provided. The filter includes at least one of the foregoing resonators. The filter provided in embodiments of this application includes the foregoing resonator, and therefore has all the foregoing beneficial effect. Details are not described herein again.

According to still another aspect, a communication device is provided. The communication device includes the foregoing filter and a mainboard. The mainboard is connected to the filter. The communication device provided in embodiments of this application includes the foregoing filter, and further includes the foregoing resonator, and therefore has all the foregoing beneficial effect. Details are not described herein again.

In some embodiments, the communication device further includes a target component. The target component is connected to the mainboard; a first side surface and a second side surface of a reference layer of the resonator, and a connection line between two ends that are of the first side surface and the second side surface and that are away from each other enclose a first region; and at least a part of the target component is located in the first region. In the foregoing disposition, the target component can be semi-enclosed via the first region. The resonator can be more tightly combined with the target component. This reduces an area occupied by the resonator and the target component on a circuit substrate of the communication device, and improves utilization of a layout of the circuit substrate.

### BRIEF DESCRIPTION OF DRAWINGS

FIG. 1 is a diagram of a structure of a communication device according to some embodiments of this application;
FIG. 2 is a block diagram of a filter according to some embodiments of this application;
FIG. 3A is a top view of a resonator in a related technology according to some embodiments of this application;
FIG. 3B is a top view of another resonator in a related technology according to some embodiments of this application;
FIG. 3C is a top view of still another resonator in a related technology according to some embodiments of this application;
FIG. 4 is a diagram of a layout in which a resonator in a related technology is combined with another component according to some embodiments of this application;
FIG. 5 is a diagram of a structure of a resonator according to some embodiments of this application;
FIG. 6A is a top view of a resonator according to some embodiments of this application;
FIG. 6B is a top view of another resonator according to some embodiments of this application;
FIG. 7A is a diagram of a layout in which a resonator is combined with another component according to some embodiments of this application;
FIG. 7B is a diagram of another layout in which a resonator is combined with another component according to some embodiments of this application;
FIG. 8A is a top view of a reference layer according to some embodiments of this application;
FIG. 8B is a top view of another reference layer according to some embodiments of this application;
FIG. 9A is a diagram of comparison between performance of a resonator in a related technology and performance of a resonator according to some embodiments disclosed;
FIG. 9B is another diagram of comparison between performance of a resonator in a related technology and performance of a resonator according to some embodiments disclosed;
FIG. 10 is a diagram of another structure of a resonator according to some embodiments of this application;
FIG. 11A is a diagram of a structure of a free-standing bulk acoustic resonator according to some embodiments disclosed;
FIG. 11B is a diagram of another structure of a free-standing bulk acoustic resonator according to some embodiments disclosed;
FIG. 12 is a diagram of a structure of a solid-mounted resonator according to some embodiments disclosed; and
FIG. 13 is a diagram of a layout in which a resonator is combined with a target component according to some embodiments of this application.

### DESCRIPTION OF EMBODIMENTS

The following clearly and completely describes technical solutions in some embodiments of this application with reference to accompanying drawings. It is clear that the described embodiments are merely some rather than all embodiments of this application. All other embodiments obtained by a person of ordinary skill in the art based on embodiments of this application shall fall within the protection scope of this application.

Unless otherwise required in the context, throughout the entire specification and claims, the term "include" is interpreted as "being open and inclusive", that is, "include but not limited to". In description of this specification, terms such as "an embodiment", "some embodiments", "an example embodiment", "an example", or "some examples" are intended to indicate that a specific feature, structure, material, or characteristic related to embodiments or examples are included in at least one embodiment or example of this application. The foregoing schematic representations of the terms do not necessarily refer to a same embodiment or example. Further, the particular feature, structure, material, or characteristic may be included in any one or more embodiments or examples in any appropriate manner.

Example implementations are described herein with reference to a sectional view and/or a plane view of the accompanying drawings as idealized example drawings. In the accompanying drawings, for clarity, thicknesses of layers and regions are increased. Thus, a change in a shape in the accompanying drawings due to, for example, manufacturing techniques and/or tolerances may be envisaged. Therefore, example implementations should not be construed as being limited to a shape of a region shown herein, but rather include shape deviations due to, for example, manufacturing. For example, an etching region shown as a rectangle typically has a bending feature. Therefore, the regions shown in the accompanying drawings are essentially examples, and their shapes are not intended to show actual shapes of regions of a device, and are not intended to limit a scope of the example implementations.

The term "example" or "for example" in embodiments of this application means used as an example, an illustration, or a description. Any embodiment or design scheme described as an "example" or "for example" in embodiments of this application should not be explained as being more preferred or having more advantages than another embodiment or design scheme. Exactly, use of the term such as "example" or "for example" is intended to present a relative concept in a specific manner.

A communication device 01 provided in this application may be a terminal product like a mobile phone, a tablet computer, or an unmanned aerial vehicle; or the communication device 01 may be a communication device like a base station, a routing device, a server, or a vehicle-mounted device.

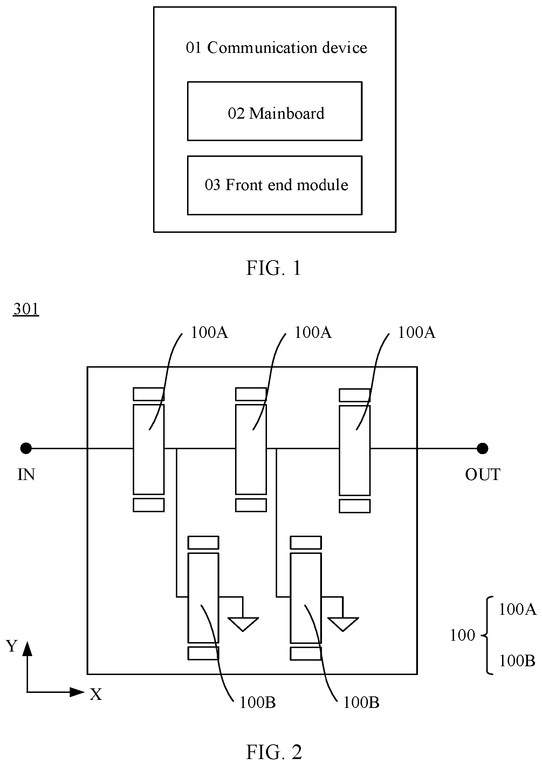

FIG. 1 is a diagram of a structure of a communication device 01 according to an embodiment of this application. As shown in FIG. 1, the communication device 01 may include a mainboard 02 and a front end module 03.

The mainboard 02 may include at least one memory and at least one processor. A memory may also be referred to as a storage medium, a storage device, or the like, and is configured to store a software program. A processor is configured to read and execute the software program in the memory. In a feasible implementation, the memory may be disposed independently of the processor. In another feasible implementation, the memory may be integrated with the processor.

The front end module 03 may be mounted on the mainboard 02, and connected to the processor on the mainboard 02. The front end module 03 is configured to receive and send a radio frequency signal. The radio frequency (radio frequency, RF) signal includes an electrical signal having a specific frequency. Usually, the radio frequency signal may include a receive signal and a transmit signal, the receive signal may be referred to as a Rx (receive) signal, and the transmit signal may be referred to as a Tx (transport) signal.

The front end module 03 may include an antenna and a radio frequency circuit, and the radio frequency circuit is connected to the processor. The radio frequency circuit may include a receive link and a transmit link. Further, the radio frequency circuit includes at least a filter 301, and the filter 301 is connected to the mainboard 02. In embodiments of this application, the filter 301 is an apparatus having a frequency selection function, and can allow a specific frequency component in a signal to pass through, and greatly attenuate another frequency component, thereby implementing the frequency selection function. In embodiments of this application, a component of the another frequency component may be defined as interference noise. The frequency selection function of the filter 301 can be used to reduce the interference noise, so that an output radio frequency signal is smooth and stable.

In embodiments of this application, the filter 301 may be but is not limited to a circuit component in a radio frequency filter, a duplexer, a radio frequency module, or another radio frequency circuit.

FIG. 2 is a block diagram of the filter 301 according to some embodiments of this application. As shown in FIG. 2, the filter 301 may include at least one first component 100A and at least one second component 100B. The filter 301 may further include an input port IN, an output port OUT, and a ground. The at least one first component 100A may be electrically connected in series between the input port IN and the output port OUT, and the second component 100B may be electrically connected between the first component 100A and the ground. A plurality of first components 100A are disposed, so that the filter 301 forms a first band stop. A plurality of second components 100B are disposed, so that the filter 301 forms a second band stop. In the foregoing disposition, the filter 301 has corresponding bandpass, so that a signal in a corresponding frequency band can pass through.

For example, the filter 301 shown in FIG. 2 may include three first components 100A and two second components 100B. Certainly, in another embodiment, a quantity of the first components 100A and a quantity of the second components 100B in the filter 301 may be correspondingly set based on an actual requirement.

Each of the first component 100A and the second component 100B may be a resonator 100. The resonator 100 may be of a structure in any one of the following embodiments.

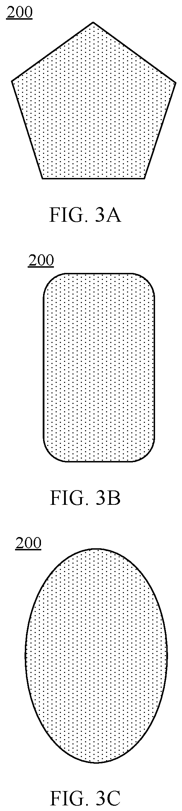

FIG. 3A is a top view of a resonator 200 in a related technology according to some embodiments of this application. FIG. 3B is a top view of another resonator 200 in a related technology according to some embodiments of this application. FIG. 3C is a top view of still another resonator 200 in a related technology according to some embodiments of this application.

As shown in FIG. 3A to FIG. 3C, in the related technology, a shape of the resonator 200 is mostly a convex polygon, for example, a rectangle, a pentagon, or an ellipse.

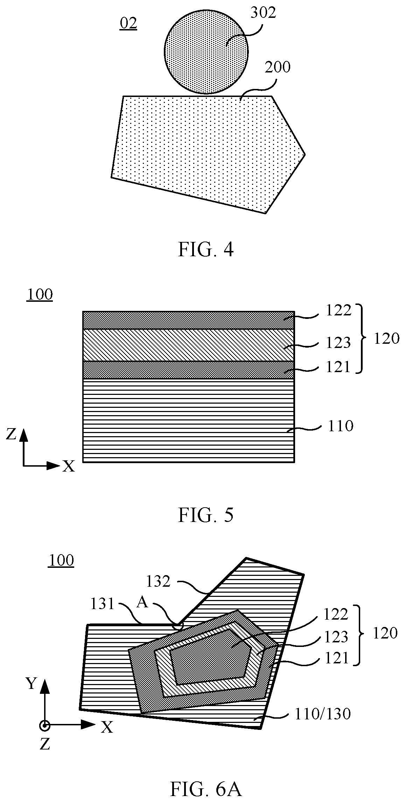

FIG. 4 is a diagram of a layout in which a resonator 200 in a related technology is combined with another component 302 according to some embodiments of this application. As shown in FIG. 4, on the layout of a circuit substrate of the filter 301, a shape of the another component 302 that matches the resonator 200 may be a circle. For example, the another component 302 may be a metal bump for soldering on the circuit substrate, for example, a solder joint or a solder pin. In addition, due to a shape characteristic of the resonator 200 in the related technology, the resonator 200 is combined with the another component 302 loosely in the related technology. In other words, a structure obtained by combining the resonator with the another component 302 occupies a large area on the layout of the circuit substrate, resulting in low utilization of a layout area of the circuit substrate of the filter. This does not help reduce the layout area of the circuit substrate, and further does not help implement miniaturization and integration of the filter. The foregoing problem is particularly obvious at a layout corner and a layout edge of the circuit substrate.

FIG. 5 is a diagram of a structure of a resonator 100 according to some embodiments of this application.

As shown in FIG. 5, the resonator 100 includes a substrate 110 and a resonance layer 120. The resonance layer 120 is located on one side of the substrate 110, the resonance layer 120 includes a first electrode 121, a second electrode 122, and a piezoelectric layer 123 that are stacked, and the piezoelectric layer 123 is located between the first electrode 121 and the second electrode 122.

Refer to FIG. 5. In some embodiments, the first electrode 121 may be disposed on a surface of one side of the substrate 110, and the second electrode 122 may be disposed on a surface of one side that is of the piezoelectric layer 123 and that is far away from the substrate 110.

In some other embodiments, positions disposed for the first electrode 121 and the second electrode 122 may be exchanged. To be specific, the second electrode 122 may be disposed on a surface of one side of the substrate 110, and the first electrode 121 may be disposed on a surface of one side that is of the piezoelectric layer 123 and that is far away from the substrate 110.

For example, the substrate 110 is a support layer of the resonator 100, and a material of the substrate 110 may be a high-resistance material. For example, the material may include one or more of monocrystalline silicon, high-resistance silicon, sapphire, silicon carbide, or the like, to reduce leakage of acoustic wave energy.

A material of the piezoelectric layer 123 may be a piezoelectric material, and the piezoelectric material may be a monocrystalline material or a polycrystalline material. Compared with the polycrystalline material, the monocrystalline material has more excellent electrical and acoustic characteristics. For example, the monocrystalline material used may include one or a combination of a lead zirconate titanate (PZT) piezoelectric ceramic, zinc oxide (ZnO), gallium nitride (GaN), aluminum nitride (AlN), and lithium niobate (LiNbO3). This is not limited in this application. In addition, a thickness of the piezoelectric layer 123 may include, for example, hundreds of nanometers to thousands of nanometers. A formed frequency of the resonator 100 can be adjusted by adjusting thicknesses of the piezoelectric layer 123, the first electrode 121, and the subsequently formed second electrode 122.

The first electrode 121 and the second electrode 122 may use a conductive material. The conductive material is, for example, one or a combination of aluminum, copper, titanium, gold, silver, platinum, and molybdenum. Alternatively, the conductive material may be another alloy material. This is not limited in this application. The first electrode 121 and the second electrode 122 may use a same conductive material, or may use different conductive materials.

In some embodiments, the first electrode 121, the piezoelectric layer 123, and the second electrode 122 may be sequentially formed in a deposition method. Further, after a corresponding film layer is formed through deposition, the corresponding film layer may be patterned based on a design layout. For example, a deposition process may include metal-organic chemical vapor deposition (metal-organic chemical vapor deposition, MOCVD), molecular beam epitaxy (molecular beam epitaxy, MBE), or pulsed laser deposition (pulsed laser deposition, PLD).

In the foregoing disposition, interconversion between a bulk acoustic wave and an electrical signal can be implemented in the piezoelectric layer 123. For example, when there is an electric field between the first electrode 121 and the second electrode 122, because the piezoelectric layer 123 is subject to a voltage, the bulk acoustic wave is generated in the piezoelectric layer 123, so that conversion from electric energy to mechanical energy (energy generated by the bulk acoustic wave) can be implemented. When the bulk acoustic wave propagates in the piezoelectric layer 123, a positive charge and a negative charge appear on a surface of the piezoelectric layer 123, and the electrical signal is generated, so that conversion from the mechanical energy to electrical energy is implemented. The foregoing process may be referred to as piezoelectric effect.

Further, the resonator 100 may implement frequency selection of the electrical signal by using the bulk acoustic wave. For example, when the piezoelectric layer 123 vibrates under the action of the voltage, a bulk acoustic wave far away from a natural frequency are gradually attenuated, and a bulk acoustic wave same as or close to the natural frequency is retained. Therefore, the retained bulk acoustic wave is a pure signal. When the piezoelectric layer 123 generates resonance under the action of the bulk acoustic wave at the natural frequency, an electrical signal generated at a resonance frequency (the resonance frequency is equal to the natural frequency) is also an electrical signal with a pure frequency, thereby implementing frequency selection of the electrical signal.

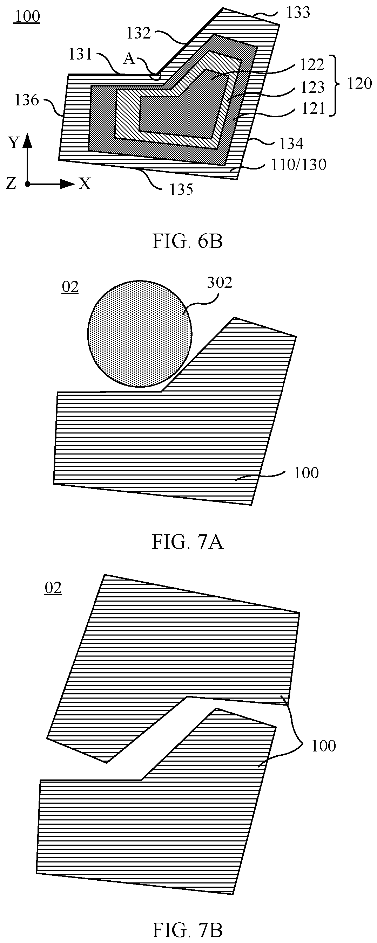

FIG. 6A is a top view of a resonator 100 according to some embodiments of this application. FIG. 6B is a top view of another resonator 100 according to some embodiments of this application.

As shown in FIG. 6A and FIG. 6B, in some embodiments, at least one of the substrate 110, the first electrode 121, the second electrode 121, and the piezoelectric layer 123 is a reference layer 130, an edge of the reference layer 130 includes a first side surface 131 and a second side surface 132 that are adjacent to each other, and an included angle A between the first side surface 131 and the second side surface 132 and located in the reference layer 130 is a reflex angle.

In embodiments of this application, the first electrode 121, the piezoelectric layer 123, and the second electrode 122 are separately patterned, to obtain film layers of different shapes. Among all film layers including the substrate 110, a film layer whose inner angle is the reflex angle may be used as the reference layer 130. For example, a reflex angle A indicates that an included angle between two side surfaces that form the reflex angle A is greater than 180°, where the two side surfaces of the reflex angle A are respectively the first side surface 131 and the second side surface 132 that are adjacent to each other.

Still refer to FIG. 5, FIG. 6A, and FIG. 6B. A projection is made on a reference surface in a stacking direction Z, to obtain an orthogonal projection formed by the resonator 100, where the stacking direction Z is a direction in which the substrate 110 and the resonance layer 120 are stacked. In embodiments of this application, it can be seen from the orthogonal projection of the resonator 100 that the inner angle A in the reference layer 130 is at a position of the reflex angle, and the first side surface 131 and the second side surface 132 that are adjacent to each other form a region recessed into the reference layer 130, namely, form a semi-enclosed region.

Positions and a quantity of the reference layers 130 may be determined based on a shape of another component 302 (for example, a solder joint or another resonator on a circuit substrate) that matches the resonator 100. The positions and the quantity of the reference layers 130 are not limited in this application. In other words, the reference layer 130 may be any one or more of the substrate 110, the first electrode 121, the second electrode 121, and the piezoelectric layer 123.

For example, refer to FIG. 6A. The reference layer 130 may be the substrate 110. A projection is made on the reference surface in the stacking direction Z, to obtain an edge of an orthogonal projection of the reference layer 130 on the reference surface, where the edge is located outside an edge of an orthogonal projection of a non-reference layer (namely, a film layer other than the reference layer 130) of the resonator 100 on the reference surface. In this case, the first side surface 131 and the second side surface 132 that form the reflex angle on the substrate 110 (the reference layer 130) may semi-enclose the solder joint on the circuit substrate, to shorten a distance between the substrate 110 and the solder joint, and further reduce a layout area of the circuit substrate occupied by the resonator 100 and the solder joint.

Alternatively, in a scenario in which a height of the solder joint is less than or equal to a thickness of a film layer of the substrate 110, an edge of an orthogonal projection of the substrate 110 on the reference plane may be located within an edge of an orthogonal projection of a non-reference layer on the reference plane. In this case, the substrate 110 may also semi-enclose the solder joint. This reduces a layout area of the circuit substrate occupied by the resonator 100 and the solder joint.

In some other examples, there may be a plurality of reference layers 130. Edges of orthogonal projections of the plurality of reference layers 130 on the reference plane may overlap, and the edges of the orthogonal projections of the plurality of reference layers 130 on the reference plane are all located outside an edge of an orthogonal projection of a non-reference layer on the reference plane.

In some other examples, refer to FIG. 6B. All film layers of the resonator 100 may be reference layers 130.

The foregoing disposition can flexibly adjust the positions and the quantity of the reference layers 130, implement combination and electrical connection with components of a plurality of different shapes, and improve layout flexibility of the resonator 100 on the circuit substrate of the filter 301.

FIG. 7A is a diagram of a layout in which a resonator 100 is combined with another component 302 according to some embodiments of this application. FIG. 7B is a diagram of another layout in which a resonator 100 is combined with another component 302 according to some embodiments of this application.

Each of FIG. 7A and FIG. 7B is a diagram of a layout obtained after a resonator 100 is combined with a solder joint or another resonator on a circuit substrate. As shown in FIG. 7A and FIG. 7B, when the resonator 100 is electrically connected to the solder joint or another resonator on the circuit substrate of a filter 301, the resonator 100 may semi-enclose the solder joint or the another resonator on the circuit substrate via a semi-enclosed region. This reduces a spacing between the resonator 100 and the solder joint or the another resonator on the circuit substrate, reduces a layout area occupied by the resonator 100 and the solder joint or the another resonator combined with the resonator 100 on the circuit substrate, and improves utilization of the layout of the circuit substrate of the filter 301.

In addition, when the circuit substrate has a same quantity of components, the resonator 100 is tightly combined with the another component 302 on the circuit substrate in embodiments of this application. This reduces a layout area occupied by the component, helps reduce the layout area of the circuit substrate, and helps implement miniaturization and integration of the filter 301.

Still refer to FIG. 6B. In some embodiments, the edge of the reference layer 130 includes a plurality of side surfaces that are sequentially head-to-tail connected, and any two of the plurality of side surfaces are not parallel.

It may be understood that a bulk acoustic wave in a BAW resonator has two transmission manners: a longitudinal wave (longitudinal mode) and a transverse wave (transverse mode). The two acoustic waves have different transmission speeds. Generally, a transmission speed of the longitudinal mode is greater than a transmission speed of the transverse mode. Therefore, the two different transmission manners generate different resonance responses. An acoustic wave propagated in a longitudinal direction (namely, the stacking direction Z) causes resonance effect, and an acoustic wave propagated in a transverse direction (perpendicular to the stacking direction Z) dissipates energy within a system, and excites an additional spurious mode. Therefore, in actual application, the BAW resonator is always inclined to use the longitudinal mode of the bulk acoustic wave, and the transverse mode needs to be suppressed.

For the resonator 100, if two or more side surfaces of a film layer of the resonator 100 are parallel, the transverse mode is amplified. This affects performance of the resonator 100.

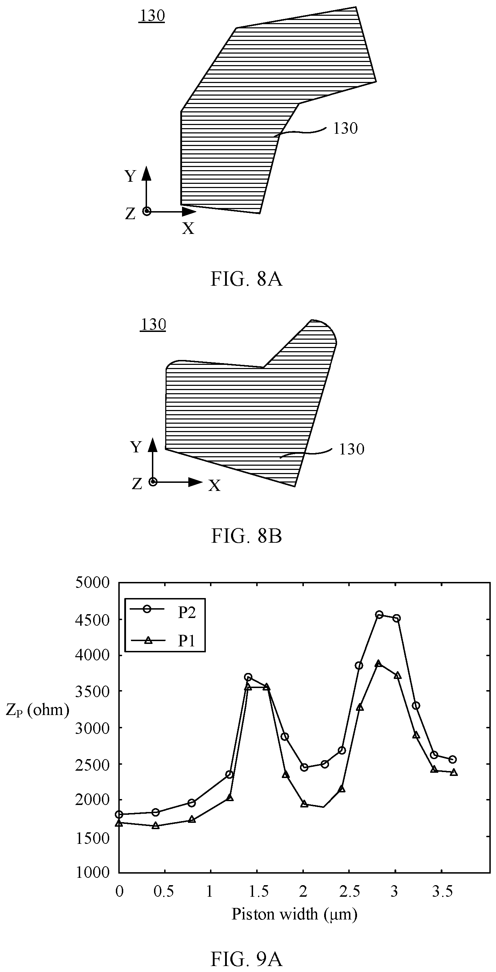

FIG. 8A is a top view of a reference layer 130 according to some embodiments of this application. FIG. 8B is a top view of another reference layer 130 according to some embodiments of this application.

Refer to FIG. 6B, FIG. 8A, and FIG. 8B. In embodiments of this application, the projection is made on the reference surface in the stacking direction Z, and any two side edges in the orthogonal projection formed by the reference layer 130 are not parallel. In other words, any two side surfaces of the edge of the film layer of the reference layer 130 are not parallel. Such disposition can reduce a possibility that the acoustic wave of the transverse mode forms resonance in the resonator 100, and suppress the transverse mode.

In some embodiments, at least one side surface includes a plane, and/or at least one side surface includes an arc surface.

In embodiments of this application, the edge of the reference layer 130 includes the plurality of side surfaces that are sequentially head-to-tail connected, and the side surface may be a plane or an arc surface. Still refer to FIG. 8A. When the plurality of side surfaces are all planes, the orthogonal projection of the reference layer 130 on the reference plane is a concave polygon. A concave polygon indicates that there is one side among all sides forming a graph, and when the side infinitely extends to two ends of a line segment of the side to form a straight line, remaining other sides are not on a same side of the straight line. In addition, there is at least one inner angle among inner angles of the concave polygon is a reflex angle.

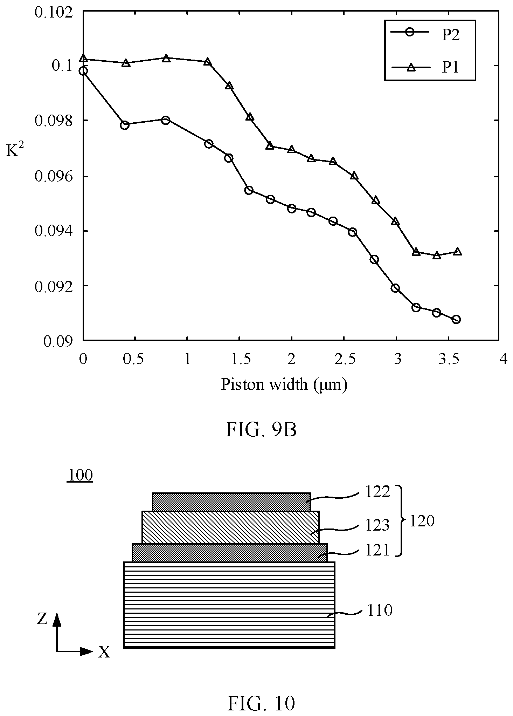

FIG. 9A is a diagram of comparison between performance of a resonator in a related technology and performance of a resonator 100 according to an embodiment of this application. FIG. 9B is another diagram of comparison between the performance of the resonator in the related technology and the performance of the resonator 100 according to this embodiment of this application.

In embodiments of this application, when the orthogonal projection of the reference layer 130 on the reference plane is the concave polygon, comparison between the performance of the resonator in the related technology and the performance of the resonator 100 is shown in FIG. 9A and FIG. 9B. In FIG. 9A, a horizontal coordinate is a piston width and is a displacement width of an edge of the second electrode 122 of the resonator 100, and a vertical coordinate is impedance Z_{P} of an anti-resonant frequency. A horizontal coordinate in FIG. 9B is the piston width and is the displacement width of the edge of the second electrode 122 of the resonator 100, and a vertical coordinate in FIG. 9B is an effective electromechanical coupling coefficient K². In addition, physical meanings represented by other parameters in FIG. 9A and FIG. 9B are respectively as follows: P1 represents a performance curve of the resonator 100 in which the orthogonal projection of the reference layer 130 is the concave polygon in embodiments of this application, and P2 represents a performance curve of the resonator in which the orthogonal projection is the convex polygon in the related technology.

Refer to FIG. 9A and FIG. 9B. Definitely, it can be learned that in embodiments of this application, when the resonator 100 and the resonator in the related technology have same related parameters, after a film layer structure of the resonator 100 is changed in embodiments of this application, that is, after the reference layer 130 whose orthogonal projection is the concave polygon is disposed, an effective electromechanical coupling coefficient K² of the resonator 100 in embodiments of this application is improved. In addition, compared with the resonator in the related technology, impedance Z_{P} of an anti-resonant frequency of the resonator 100 in embodiments of this application decreases (for example, Z_{P} decreases by 10-15%).

In conclusion, it can be learned from a test result that, overall performance of the resonator 100 in embodiments of this application is better than performance of the resonator in the related technology. In other words, in embodiments of this application, after the reference layer 130 whose orthogonal projection is the concave polygon is disposed, operating performance of the resonator 100 can be improved.

Still refer to FIG. 8B. When the plurality of side surfaces have an arc surface, this helps smooth a graphic structure formed by the plurality of side surfaces of the resonator 100. When the resonator 100 is combined with the another component 302 on the circuit substrate of the filter 301, this helps reduce a distance between the resonator 100 and the another component 302 after combination, and reduce a layout area occupied by the resonator 100 and the another component 302 after combination on the circuit substrate. In addition, compared with a side surface, in the resonator 100, being a plane, the side surface of the arc surface is more flexible, and can flexibly adapt to components of different shapes, improve a fitting degree of the resonator 100 and the another component 302 in terms of shapes, that is, reduce the distance between the resonator 100 and the another component 302 after combination, and reduce the occupied layout area of the circuit substrate.

In conclusion, when the plurality of side surfaces in the resonator 100 provided in embodiments of this application have the arc surface, this can effectively improve flexibility of adapting the resonator 100 to the another component 302, reduce the layout area of the circuit substrate occupied by the resonator 100 and the another component 302 after combination, improve utilization of a layout of the circuit substrate, and help implement further miniaturization and integration of the filter 301.

In some embodiments, a chamfer or a fillet exists between two adjacent side surfaces.

Still refer to FIG. 8B. In embodiments of this application, chamfering processing is performed on an included angle formed between every two adjacent side surfaces of the reference layer 130 of the resonator 100. For example, chamfering may include a chamfer or a fillet. In other words, after chamfering, the included angle formed between the two adjacent side surfaces is processed and cut into an oblique surface or an arc surface. Chamfering processing can further reduce a likelihood of parallelism between the plurality of side surfaces, and suppress the transverse mode. In addition, chamfering processing is performed on an included angle that is very sharp or protruding in an included angle formed by two adjacent side surfaces in the resonator 100. This helps improve a density at which the resonator 100 is combined with another component 302 on the circuit substrate of the filter 301 when the resonator 100 is combined with the another component 302 on the circuit substrate of the filter 301. In addition, this reduces the layout area on the circuit substrate, improves utilization of the layout of the circuit substrate, and further helps implement miniaturization and integration of the filter 301. For example, when chamfering processing is performed on an included angle formed by two adjacent side surfaces in the resonator 100, a chamfer or a fillet may be obtained.

In some embodiments, at least one of the substrate 110, the first electrode 121, the second electrode 122, and the piezoelectric layer 123 is a non-reference layer, and the edge of the reference layer 130 extends beyond an edge of the non-reference layer.

Still refer to FIG. 5, FIG. 6A, and FIG. 6B. In embodiments of this application, in the reference layer 130, at the position of the inner angle A being the reflex angle, the first side surface 131 and the second side surface 132 that are adjacent to each other form the region recessed into the reference layer 130. Therefore, the region that is recessed inside and that is at the position may be used as a semi-enclosed region, and the film layer edge with the semi-enclosed region is tightly fitted with a peripheral component. This can reduce the layout area, occupied by the resonator 100 and the component combined with and fitted with the resonator 100, of the circuit substrate, and improve utilization of the layout of the circuit substrate.

In embodiments of this application, the film layer edge of the reference layer 130 of the resonator 100 extends beyond the film layer edge of the non-reference layer. Such disposition prevents, when the resonator 100 is combined with another component 302 on the circuit substrate, a shape of the non-reference layer from interfering with combination of the resonator 100 and the another component 302 on the circuit substrate. To be specific, this avoids that a gap between the resonator 100 and the another component 302 is large, an area occupied on the circuit substrate is large, and utilization of the layout of the circuit substrate is reduced because the film layer edge of the non-reference layer extends beyond the film layer edge of the reference layer 130, and when the resonator 100 is combined with another component 302 on the circuit substrate, the film layer edge of the non-reference layer shields the film layer edge of the semi-enclosed region on the reference layer 130 and blocks the another component 302 combined with the resonator 100 on the circuit substrate from entering the semi-enclosed region of the reference layer 130.

In conclusion, in embodiments of this application, the edge of the film layer of the reference layer 130 of the resonator 100 extends beyond the edge of the film layer of the non-reference layer, so that the another component 302 enters the semi-enclosed region of the reference layer 130 when the resonator 100 is combined with the another component 302 on the circuit substrate. The resonator 100 is tightly combined with the another component 302. This reduces the area occupied by the resonator 100 and the another component 302 after combination on the circuit substrate, helps further reduce the layout area of the circuit substrate, and promotes further miniaturization and integration of the filter 301.

In some embodiments, the substrate 110 is the reference layer 130, and in any two film layers in the resonance layer 120, an edge of a film layer close to the substrate 110 extends beyond an edge of a film layer far away from the substrate 110.

FIG. 10 is a diagram of another structure of a resonator 100 according to some embodiments of this application.

As shown in FIG. 10, areas of film layers of the substrate 110, the first electrode 121, the piezoelectric layer 123, and the second electrode 122 in the resonator 100 sequentially decrease in the stacking direction Z, and the substrate 110 is used as the reference layer 130. The edge of the film layer of the substrate 110 extends beyond edges of other film layers. In embodiments of this application, the substrate 110 is used as the reference layer 130, so that support stability of a bottom of the resonator 100 can be increased, and stability of an overall structure of the resonator 100 is improved.

In addition, the resonator 100 is structurally formed by sequentially stacking a plurality of film layer structures in the stacking direction Z. As a quantity of stacked film layers increases, stress generated in a process procedure causes a center of gravity of adjacent film layers to deviate. In embodiments of this application, between a plurality of film layers included in the resonance layer 120, in addition to that areas of the film layers sequentially decrease in the stacking direction Z, in two adjacent film layers, an edge of a film layer close to the substrate 110 extends beyond an edge of a film layer far away from the substrate 110. In such disposition, in a process of stacking the two adjacent film layers, even if a center of gravity deviates, the film layer close to the substrate 110 can still provide sufficient support force for the film layer far away from the substrate 110.

For example, in a process of forming the piezoelectric layer 123 on a surface of a side that is of the first electrode 121 and that is away from the substrate 110, a center of gravity of the piezoelectric layer 123 deviates due to stress, and is far away from a position of a center of gravity of the first electrode 121. As a result, a center of gravity of a stacked structure formed by the first electrode 121 and the piezoelectric layer 123 changes. However, an area of the film layer of the first electrode 121 is greater than an area of the film layer of the piezoelectric layer 123. This can effectively reduce a distance of the center of gravity deviated between the first electrode 121 and the piezoelectric layer 123, and reduce a likelihood that a structure of the resonator 100 is unstable because the center of gravity deviates. In addition, an edge of the film layer of the first electrode 121 extends beyond an edge of a film layer of the piezoelectric layer 123. Even if a position of the center of gravity of the piezoelectric layer 123 deviates, the first electrode 121 can still provide sufficient support force for the entire piezoelectric layer 123. This ensures stability of the stacked structure formed by the first electrode 121 and the piezoelectric layer 123, and further improves stability of the overall structure of the resonator 100.

Still refer to FIG. 6B. In some embodiments, shapes of orthogonal projections of any two film layers of the substrate 110, the first electrode 121, the second electrode 122, and the piezoelectric layer 123 on the reference plane are the same, and the reference plane is perpendicular to a direction in which the substrate 110 and the resonance layer 120 are stacked.

In embodiments of this application, the projection is made on the reference surface in the stacking direction Z, and the shapes of the orthogonal projections of any two film layers in the plurality of film layers of the resonator 100 on the reference plane are the same. With reference to the foregoing embodiment, the edge of the film layer of the substrate 110 extends beyond an edge of a film layer of the resonance layer 120, and in any two film layers of the resonance layer 120, the edge of the film layer close to the substrate 110 extends beyond the edge of the film layer far away from the substrate 110, to obtain an orthogonal projection of the resonator 100, as shown in FIG. 6B. Such disposition helps reduce the impedance Z_{P} of the anti-resonant frequency of the resonator 100 while ensuring stability of the overall structure of the resonator 100, and improve the effective electromechanical coupling coefficient K² of the resonator 100. The effective electromechanical coupling coefficient K² represents a relative frequency of a series resonance frequency and a parallel resonance frequency of the resonator 100, and also represents a bandwidth of the resonator 100.

Still refer to FIG. 6B. In some embodiments, the reference layer 130 includes the first side surface 131, the second side surface 132, a third side surface 133, a fourth side surface 134, a fifth side surface 135, and a sixth side surface 136 that are sequentially head-to-tail connected. Included angles between the first side surface 131 and the sixth side surface 136, between the second side surface 132 and the third side surface 133, and between the fourth side surface 134 and the fifth side surface 135 and located in the reference layer 130 are obtuse angles. Included angles between the third side surface 133 and the fourth side surface 134, and between the fifth side surface 135 and the sixth side surface 136 and located in the reference layer 130 are acute angles.

In embodiments of this application, the reference layer 130 may include the six side surfaces that are sequentially head-to-tail connected, and an included angle located in the reference layer 130 exists between every two adjacent side surfaces. For example, after the six side surfaces of the reference layer 130 are head-to-tail connected, six included angles are formed. Except that the included angle between the first side surface 131 and the second side surface 132 is the reflex angle, the remaining included angles are divided into three obtuse angles and two inner angles, and the obtuse angles and the inner angles are alternately distributed sequentially. In such disposition, an angle of each included angle can be changed to implement change of extension directions of two side surfaces that form the included angle, so that the formed reference layer 130 has a regular shape. This helps combine and splice the resonator with the another component 302 on the layout of the circuit substrate.

In addition, in actual application, the resonator 100 on the layout of the circuit substrate of the filter 301 is mostly at an edge or a corner. In embodiments of this application, the included angle between the fourth side surface 134 and the fifth side surface 135 and located in the reference layer 130 is set to the obtuse angle, to effectively reduce a spacing between the included angle and the edge or the corner of the circuit substrate, reduce a spacing between the resonator 100 and the edge or the corner of the circuit substrate, avoid a waste of the layout area of the circuit substrate caused by the resonator 100, help subsequently place the component on the layout of the circuit substrate, and improve utilization of the layout of the circuit substrate. By improving utilization of the layout of the circuit substrate, this can reduce the layout area of the circuit substrate and help implement miniaturization and integration of the filter 301 when the filter 301 includes a same quantity of components.

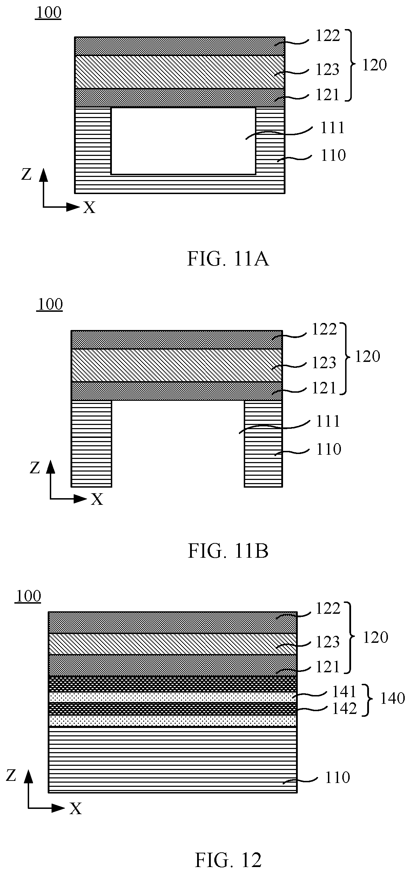

FIG. 11A is a diagram of a structure of a free-standing bulk acoustic resonator according to some embodiments disclosed. FIG. 11B is a diagram of another structure of a free-standing bulk acoustic resonator according to some embodiments disclosed.

As shown in FIG. 11A and FIG. 11B, in some embodiments, the substrate 110 has a cavity 111. The resonance layer 120 and the cavity 111 overlap in the first direction Z, and the first direction Z is a direction in which the substrate 110 and the resonance layer 120 are stacked.

In embodiments of this application, the substrate 110 has the cavity 111. For example, the cavity 111 may have at least one opening. Refer to FIG. 11A. When the cavity 111 has one opening, the opening is located on a side that is of the substrate 110 and that is close to the resonance layer 120. Refer to FIG. 11B, when the cavity 111 has two openings, the two openings are disposed opposite to each other in the first direction Z, any one of the two openings is disposed on a side that is of the substrate 110 and that is close to the resonance layer 120, and the other opening is disposed on a side that is of the substrate 110 and that is far away from the resonance layer 120. The first direction Z is a direction in which the substrate 110 and the resonance layer 120 are stacked.

In this case, the resonator 100 whose substrate 110 has the cavity 111 may form the free-standing bulk acoustic resonator (free-standing bulk acoustic resonator, FBAR). The resonance layer 120 and the cavity 111 overlap in the first direction Z, that is, the first electrode 121, the second electrode 122, and the piezoelectric layer 123 overlap with the cavity 111 in the first direction Z, so that an overlapping region forms an effective region used as a region for triggering resonance effect.

In an actual application process, an electrical signal needs to be applied to each of the first electrode 121 and the second electrode 122. After the resonator 100 receives an external voltage signal, the piezoelectric layer 123 between the first electrode 121 and the second electrode 122 generates mechanical deformation under inverse piezoelectric effect, so that the piezoelectric layer 123 changes with the external voltage signal. For example, the piezoelectric layer 123 may expand or contract with the external voltage signal.

The mechanical deformation of the piezoelectric layer 123 may generate vibration, and the vibration excites a bulk acoustic wave propagating in the stacking direction Z in the film layer in which the piezoelectric layer 123 is located. When the bulk acoustic wave propagates to an interface between air and each of the first electrode 121 and the second electrode 122, the bulk acoustic wave is reflected back. The bulk acoustic wave is repeatedly reflected back and forth in the resonance layer 120 of the resonator 100, to form oscillation. Further, when a wavelength of the bulk acoustic wave propagating in the resonance layer 120 of the resonator 100 reaches a specific length, standing wave oscillation is formed. The bulk acoustic wave has two transmission manners: a longitudinal wave and a transverse wave. The two acoustic waves have different transmission speeds. Generally, a transmission speed of a longitudinal mode is greater than a transmission speed of a transverse mode. Therefore, the two different transmission manners generate different resonance responses. An acoustic wave propagated in a longitudinal direction (namely, parallel to the first direction Z) causes resonance effect, and an acoustic wave propagated in a transverse direction (namely, perpendicular to the first direction Z) dissipates energy within a system, excites an additional spurious mode, and needs to be suppressed.

FIG. 12 is a diagram of a structure of a solid-mounted resonator according to some embodiments disclosed.

As shown in FIG. 12, in some embodiments, the resonator 100 further includes a reflection layer 140, located between the substrate 110 and the resonance layer 120, the resonance layer 120 and the reflection layer 140 overlap in the first direction Z, the reflection layer 140 includes a high acoustic impedance layer 141 and a low acoustic impedance layer 142 that are alternately stacked in the first direction Z, and the first direction Z is a direction in which the substrate 110 and the resonance layer 120 are stacked.

In embodiments of this application, the reflection layer 140 is further disposed between the substrate 110 and the resonance layer 120, and the reflection layer 140 includes the high acoustic impedance layer 141 and the low acoustic impedance layer 142 that are alternately stacked in the first direction Z. The first direction Z is a direction in which the substrate 110 and the resonance layer 120 are stacked. For example, a material of the high acoustic impedance layer 141 may be one or a combination of aluminum, titanium, silicon, molybdenum, tungsten, aluminum nitride (AlN), and silicon dioxide (SiO2); and a material of the low acoustic impedance layer 142 may be one or a combination of aluminum nitride (AlN), aluminum, titanium, silicon, silicon dioxide (SiO2), molybdenum, and tungsten. This is not limited in this application.

In this case, the resonator 100 having the reflection layer 140 may form the solid-mounted resonator (solid-mounted resonator, SMR). The resonance layer 120 and the reflection layer 140 overlap in the first direction Z, that is, the first electrode 121, the second electrode 122, and the piezoelectric layer 123 overlap with the reflection layer 140 in the first direction Z, so that an overlapping region forms an effective region as a region for triggering resonance effect. Compared with the free-standing bulk acoustic resonator in the foregoing embodiment, the solid-mounted resonator in this embodiment on which the cavity does not need to be manufactured on the substrate 110 therefore has a more stable structure. In addition, after an etching process of preparing the cavity is removed, a preparation success rate of the solid-mounted resonator is higher than that of the free-standing bulk acoustic resonator.

In an actual application process, a main difference between the solid-mounted resonator and the free-standing bulk acoustic resonator lies in a structure of reflecting the acoustic wave. To be specific, the free-standing bulk acoustic resonator in the foregoing embodiment uses a cavity structure constructed in the substrate 110 below the resonance layer 120 to reflect the acoustic wave and limit energy. However, the solid-mounted micro resonator uses the reflection layer that has the high acoustic impedance layer 141 and the low acoustic impedance layer 142 and that is constructed between the resonance layer 120 and the substrate 110 to reflect the acoustic wave and limit energy.

The resonator 100 provided in some of the foregoing embodiments may be combined with and electrically connected to the another component 302 on the circuit substrate of the filter 301, or may be combined with and electrically connected to a target component in the communication device 01.

In some embodiments, the communication device 01 further includes the mainboard 02 and a target component 303. The target component 303 is connected to the mainboard 02; a first side surface 131 and a second side surface 132 of a reference layer 130 of the resonator 100, and a connection line between two ends that are of the first side surface 131 and the second side surface 132 and that are away from each other enclose a first region 150; and at least a part of the target component 303 is located in the first region 150.

In embodiments of this application, the projection is made on the reference surface in the stacking direction Z, to obtain an orthogonal projection of the resonator 100. It can be seen from the orthogonal projection of the resonator 100 that there is an inner angle A at the reference layer 130 of the resonator 100 as a reflex angle, and at a position of the reflex angle A, the connection line between the two ends that are of the first side surface 131 and the second side surface 132 and that are away from each other, and the first side surface 131 and the second side surface 132 that are adjacent to each other enclose a structure recessed into the reference layer 130, to form the semi-enclosed first region 150 at the position. The connection line between the two ends that are of the first side surface 131 and the second side surface 132 and that are away from each other may be a straight line.

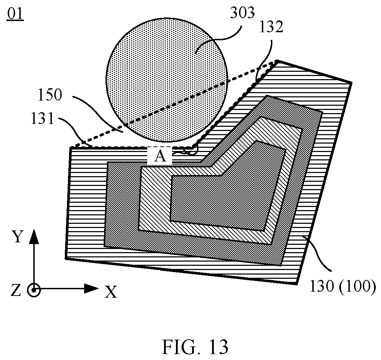

FIG. 13 is a diagram of a layout in which the resonator 100 is combined with the target component 303 according to an embodiment of this application.

For example, when orthogonal projections of the first side surface 131 and the second side surface 132 on the reference plane are straight lines, refer to FIG. 13, the first region is a triangle. In embodiments of this application, when the resonator 100 is matched with the target component 303 on the circuit substrate of the communication device 01, the resonator 100 can semi-enclose the target component 303 on the circuit substrate via the semi-enclosed first region 150. The resonator 100 can be tightly combined with the target component 303 on the circuit substrate. This reduces an area occupied by an overall structure obtained by combining the resonator 100 with the target component 303 on the circuit substrate, and further improves utilization of a layout of the circuit substrate. In addition, when the circuit substrate of the communication device 01 has a same quantity of components, in embodiments of this application, the resonator 100 is tightly combined with the target component 303 on the circuit substrate. This reduces the layout area occupied by the overall structure obtained after combination, helps reduce the layout area of the circuit substrate, and further helps implement miniaturization and integration of the communication device 01.

In some other examples, orthogonal projections of the first side surface 131 and the second side surface 132 on the reference plane may be curves. In this case, the first region 150 is in a triangular shape. To be specific, two adjacent side edges in the triangular shape are arc-shaped.

The foregoing descriptions are merely specific implementations of the present invention, and are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A resonator, comprising:
a substrate; and
a resonance layer, located on one side of the substrate, wherein the resonance layer comprises a first electrode, a second electrode, and a piezoelectric layer that are stacked, and the piezoelectric layer is located between the first electrode and the second electrode; and
at least one of the substrate, the first electrode, the second electrode, and the piezoelectric layer is a reference layer, an edge of the reference layer comprises a first side surface and a second side surface that are adjacent to each other, and an included angle between the first side surface and the second side surface and located in the reference layer is a reflex angle.

2. The resonator according to claim 1, wherein the edge of the reference layer comprises a plurality of side surfaces that are sequentially head-to-tail connected, and any two of the plurality of side surfaces are not parallel.

3. The resonator according to claim 2, wherein at least one side surface comprises a plane, and/or at least one side surface comprises an arc surface.

4. The resonator according to claim 2 or 3, wherein a chamfer or a fillet exists between two adjacent side surfaces.

5. The resonator according to any one of claims 1 to 4, wherein at least one of the substrate, the first electrode, the second electrode, and the piezoelectric layer is a non-reference layer, and the edge of the reference layer extends beyond an edge of the non-reference layer.

6. The resonator according to any one of claims 1 to 5, wherein the substrate is the reference layer, and in any two film layers in the resonance layer, an edge of the film layer close to the substrate extends beyond an edge of the film layer far away from the substrate.

7. The resonator according to claim 6, wherein shapes of orthogonal projections of any two film layers of the substrate, the first electrode, the second electrode, and the piezoelectric layer on a reference plane are the same, and the reference plane is perpendicular to a direction in which the substrate and the resonance layer are stacked.

8. The resonator according to claim 6 or 7, wherein the reference layer comprises the first side surface, the second side surface, a third side surface, a fourth side surface, a fifth side surface, and a sixth side surface that are sequentially head-to-tail connected; included angles between the first side surface and the sixth side surface, between the second side surface and the third side surface, and between the fourth side surface and the fifth side surface and located in the reference layer are obtuse angles; and included angles between the third side surface and the fourth side surface, and between the fifth side surface and the sixth side surface and located in the reference layer are acute angles.

9. The resonator according to any one of claims 1 to 8, wherein the substrate has a cavity; and
the resonance layer and the cavity overlap in a first direction, and the first direction is the direction in which the substrate and the resonance layer are stacked.

10. The resonator according to any one of claims 1 to 8, further comprising:
a reflection layer, located between the substrate and the resonance layer, wherein the resonance layer and the reflection layer overlap in a first direction, the reflection layer comprises a high acoustic impedance layer and a low acoustic impedance layer that are alternately stacked in the first direction, and the first direction is the direction in which the substrate and the resonance layer are stacked.

11. A filter, comprising at least one resonator according to any one of claims 1 to 10.

12. A communication device, comprising:
the filter according to claim 11; and
a mainboard, wherein the mainboard is connected to the filter.

13. The communication device according to claim 12, further comprising a target component, wherein the target component is connected to the mainboard; a first side surface and a second side surface of a reference layer of the resonator, and a connection line between two ends that are of the first side surface and the second side surface and that are away from each other enclose a first region; and at least a part of the target component is located in the first region.
